# EUROPEAN PATENT APPLICATION

(11) **EP 1 725 080 A1**
(43) Date of publication of application: **22.11.2006**
(21) Application number: 05720050.3
(22) Date of filing: 04.03.2005
(51) Int. Cl.: H05B 33/14, H05B 33/10

(54) **ORGANIC ELECTROLUMINESCENT DEVICE, METHOD FOR MANUFACTURING SAME AND ORGANIC SOLUTION**

(30) Priority: 11.03.2004 JP 2004069491
(71) Applicant: IDEMITSU KOSAN CO., LTD., Tokyo 100-8321 (JP)
(72) Inventor: KONDO, Hirofumi, Sodegaura-shi, Chiba 2990293 (JP); IKEDA, Hidetsugu, Sodegaura-shi, Chiba 2990293 (JP); INOUE, Tetsuya, Sodegaura-shi, Chiba 2990293 (JP); JUNKE, Tadanori, Sodegaura-shi, Chiba 2990293 (JP)
(74) Representative: Gille Hrabal Struck Neidlein Prop Roos
(86) International application number: PCT/JP2005/003778
(87) International publication number: WO 2005/089026

(57) **Abstract**

An organic electroluminescence (EL) device in which an organic thin film layer having a plurality of layers can be formed using any desired materials for an organic EL device in a simple and convenient production step, i.e., in accordance with a wet process, and which exhibits a great efficiency of light emission and has a long lifetime, a process for producing the device and an organic solution for an organic EL device realizing the process are provided. The device comprises at least one organic thin film layer in a plurality of layers containing at least a light emitting layer and sandwiched between a cathode and an anode those composing the organic electroluminescence device, wherein the organic thin film layer is formed in accordance with a wet process using a mixed solvent comprising a good solvent and a poor solvent. The process is a wet process using the mixed solvent. The organic solution is obtained by dissolving materials for an organic EL device forming the organic thin film layer into a mixed solvent comprising a good solvent and a poor solvent.

## Description

### TECHNICAL FIELD

The present invention relates to an organic electroluminescence ("electroluminescent" and "electroluminescence" will be referred to as "EL", hereinafter) device, a process for producing the device and an organic solution for an organic EL device. More particularly, the present invention relates to an organic EL device in which an organic thin film layer having a plurality of layers can be formed using any desired materials for an organic EL device in a simple and convenient production step, i.e., in accordance with a wet process, and which exhibits a great efficiency of light emission and has a long lifetime, a process for producing the device and an organic solution for an organic EL device realizing the process.

### BACKGROUND ART

As the development in the information communication industry is accelerated, display devices exhibiting higher performance are required, and organic EL devices are attracting attention as the display device of the next generation.
As the display device of the spontaneous light emission type, organic EL devices have advantages not only in their wide view angle and their excellent contrast but also their quick response time. In general, an organic EL device is constituted with a light emitting layer and a pair of electrodes disposed at both sides of the light emitting layer. The light emission is a phenomenon such that electrons are injected at the side of the cathode and holes are injected at the side of the anode when an electric field is applied to the electrodes, the electrons and the holes are recombined in the light emitting layer to form an excited state, and the energy formed when the excited state returns to the ground state is emitted as light.
When an electron and a hole are recombined, a singlet excimer or a triplet excimer is formed depending on the multiplicity of spin thereof. The ratio of the amounts of the singlet excimer to the triplet excimer formed by the recombination is 1:3 in accordance with the simple spin statistics. Light emission from the singlet excimer is called the fluorescence, and light emission from the triplet excimer is called the phosphorescence. An organic EL device utilizing the former light emission is called the EL device of the fluorescence type, and an organic EL device utilizing the latter light emission is called the EL device of the phosphorescence type. In general, the lifetime of the triplet excited state (several seconds to sub-milliseconds) is longer than the lifetime of the singlet excited state (several nanoseconds to several tens nanoseconds) since the radiative transition from the triplet excited state to the singlet ground state is forbidden based on the spin selection rule. Since the triplet excimer stays in the excited state for a longer time, the probability that the energy of the triplet excited state is lost due to collision with solvent molecules and crystal lattices (non-radiative inactivation) is very great. Therefore, phosphorescence from an organic compound comprising light atoms is rarely observed at the room temperature. Triplet excimers formed at the inside of an ordinary organic EL device is thermally inactivated without emission of light.

As an organic EL device of the fluorescence type, an organic EL device utilizing a low molecular weight aromatic diamine and an aluminum complex compound as the materials for forming the light emitting layer is reported (Non-Patent Reference 1). Light emitting materials such as coumarin derivatives, tetraphenylbutadiene derivatives, bisstyrylarylene derivatives and oxadiazole derivatives are known, and it is reported that emission of light in the visible region ranging from blue color to red color can be obtained from these materials. Therefore, development of a color display device using these light emitting materials is expected (for example, Patent References 1 to 3). Devices using anthracene derivatives are described in Patent References 4 to 7. Thin films of these low molecular weight compounds have been prepared in accordance with the vacuum vapor deposition process. However, the vacuum vapor deposition process has drawbacks in that the production cost is expensive, application to substrates having a great area is not possible and mass production is not easy since the vacuum vapor deposition is a high vacuum process requiring an apparatus having a great size.
In general, an EL device obtained by vapor deposition of low molecular weight compounds has a multilayer structure such as a structure of an anode / a hole injecting layer / a hole transporting layer / a light emitting layer / an electron transporting layer / an electron injecting layer / a cathode. The EL performances such as a great efficiency of light emission and a long lifetime can be achieved by separately carrying out each process such as injection of carriers, transportation of carriers, recombination of carriers and light emission in the layer specific for the process.
As the EL device of the phosphorescence type, an organic EL device using an aluminum complex compound and a platinum porphyrin as the materials for the light emitting layer is reported (Non-Patent Reference 2). An organic EL device using a carbazole derivative and an iridium complex compound is also reported (Non-Patent Reference 3). In these organic devices, the radiative transition from the triplet excited state to the singlet ground state is made possible by utilizing the spin-orbital interaction of the heavy metal atom. In general, the EL device of the phosphorescence type exhibits a more excellent efficiency of light emission than that of the EL device of the fluorescence type since the EL device of the phosphorescence type utilizes the triplet excimer which is formed statistically in a greater amount.

An organic EL device using a polymer such as poly(p-phenylenevinylene) (PPV) and poly(2-methoxy-5-(2'-ethylhexyloxy)-1,4-phenylenevinylene) as the material for forming the light emitting layer is reported (Non-Patent Reference 4). A soluble PPV in which a functional group improving the solubility into an organic solvent is introduced is developed. Due to this development, the light emitting layer can be formed from a solution containing PPV derivatives in accordance with a wet process for film formation such as the spin coating process and the ink jet process, and a device can be obtained easily. An organic electronic light emitting device using PPV or a derivative thereof as the material for the light emitting layer enables emission of light having a color ranging from green to orange. However, the polymer material has a drawback in that obtaining a highly pure material is not easy since purification is difficult, and the performance of the polymer material is not so good as that of the low molecular weight compounds of the vapor deposition type described above when the polymer material is actually used in an organic EL device.
In general, a polymer EL device has a structure of an anode / a hole injecting layer / a light emitting layer / a cathode. A water-soluble electrically conductive polymer compound such as poly(ethylenedioxythiophene):polystyrenesulfonic acid (PEDOT:PSS) and polyaniline:camphorsulfonic acid is used for the hole injecting layer, and a light emitting polymer compound soluble in an organic solvent (for example, toluene, xylene and dichloroethane) such as PPV described above and polyfluorene is used for the light emitting layer. In other words, the interface of the hole transporting layer and the light emitting layer is formed with solvents exhibiting no miscibility with each other such as water and an organic solvent.
A low weight molecular compound has an advantage in that an excellent efficiency of light emission and a long half lifetime of the luminance can be achieved when the low molecular weight compound is used for an organic EL device since the low molecular weight compound can be easily prepared via a short route of synthesis and can be highly purified in accordance with a conventional technology such as the column chromatography and re-crystallization. However, the low molecular weight compound is mostly dissolved with difficulty and cannot be used for a simple and convenient conventional wet process (or a wet film forming process). Although the use of a soluble low molecular weight compound is attempted, a drawback arises in that the property of the obtained EL device is very poor when the low molecular weight compound is used for a device having the same multilayer structure as that of the device using the polymer compound (an anode / a hole injecting layer / a light emitting layer / a cathode). Therefore, it is required that the same multilayer structure as that of the organic EL device prepared by vapor deposition of low molecular weight compounds (an anode / a hole injecting layer / a hole transporting layer / a light emitting layer / an electron transporting layer / an electron injecting layer / a cathode) be realized in accordance with a wet process. However, the multilayer structure cannot be formed in accordance with the conventional wet process since a lower layer is dissolved during the formation of an upper layer, and the performance of the organic EL device remains very poor.

As an example of the formation of films in an organic EL device having a multilayer structure in accordance with a wet process, a technology is disclosed in Patent Reference 8, in which, in an organic EL device comprising a plurality of organic layers which comprise a first organic layer and a second organic layer disposed adjacent to each other, the first organic layer is formed in accordance with a wet process using a first solution which is obtained by dissolving a first organic material purified by re-precipitation with a first solvent into a second organic solvent, and the second organic layer is formed on the first organic layer in accordance with a wet process using a second solution obtained by dissolving a second organic material into the first solvent. In general, a material for an organic EL device exhibits a more excellent property by purifying to a greater purity. However, the re-precipitation is not suitable for purifying a material for an organic EL material to a great purity, and an organic EL device exhibiting excellent performance cannot be prepared in accordance with the above process. Moreover, since the poor solvent used for the re-precipitation has poor ability to dissolve a material for an organic EL device, it is actually very difficult that the second material for an organic EL device dissolved into the above poor solvent is selected.
Technology is disclosed in Patent References 9 to 18, in which a second material for an organic EL device is dissolved into a solvent having a solubility parameter at the outside of the range where a first material for an organic EL device is dissolved, and the second material for an organic EL device is laminated on the thin film of the first material for an organic EL device in accordance with a wet process. However, in general, a case such that materials for an organic EL device have solubility parameters greatly different from each other depending on the type of the material is very rare. Therefore, it is difficult that this technology is applied to any desired materials for an organic EL device.

[Patent Reference 1] Japanese Patent Application Laid-Open No. Heisei 8(1996)-239655.
[Patent Reference 2] Japanese Patent Application Laid-Open No. Heisei 7(1995)-138561.
[Patent Reference 3] Japanese Patent Application Laid-Open No. Heisei 3(1991)-200889.
[Patent Reference 4] United States Patent No. 0593572.
[Patent Reference 5] Japanese Patent Application Laid-Open No. Heisei 8(1996)-012600.
[Patent Reference 6] Japanese Patent Application Laid-Open No. 2000-344691.
[Patent Reference 7] Japanese Patent Application Laid-Open No. Heisei 11(1999)-323323.
[Patent Reference 8] Japanese Patent Application Laid-Open No. 2001-284045.
[Patent Reference 9] Japanese Patent Application Laid-Open No. Heisei 11(1999)-251065.
[Patent Reference 10] Japanese Patent Application Laid-Open No. Heisei 11(1999)-251066.
[Patent Reference 11] Japanese Patent Application Laid-Open No. 2000-77187.
[Patent Reference 12] Japanese Patent Application Laid-Open No. 2001-284045.
[Patent Reference 13] Japanese Patent Application Laid-Open No. 2002-299061.
[Patent Reference 14] Japanese Patent Application Laid-Open No. 2002-305078.
[Patent Reference 15] Japanese Patent Application Laid-Open No. 2002-313563.
[Patent Reference 16] Japanese Patent Application Laid-Open No. 2002-313578.
[Patent Reference 17] Japanese Patent Application Laid-Open No. 2002-319487.
[Patent Reference 18] Japanese Patent Application Laid-Open No. 2002-319488.
[Non-Patent Reference 1] Appl. Phys. Lett., 51, 913, 1987.
[Non-Patent Reference 2] Nature, 395, 151, 1998.
[Non-Patent Reference 3] Appl. Phys. Lett., 75, 4, 1999.
[Non-Patent Reference 4] Nature, 347, 539, 1990; and Appl. Phys. Lett., 58, 1982, 1991.

### DISCLOSURE OF THE INVENTION

The present invention has been made to overcome the above problems and has an object of providing an organic EL device in which an organic thin film layer having a plurality of layers can be formed using any desired materials for an organic EL device in a simple and convenient production step, i.e., in accordance with a wet process, and which exhibits a great efficiency of light emission and has a long lifetime, a process for producing the device and an organic solution for an organic EL device realizing the process.

As the result of extensive studies by the present inventors to achieve the above object, it was found that an organic thin film of an organic EL device could be formed in accordance with a wet process by dissolving materials for forming the organic thin film layer into a mixed solvent comprising a good solvent and a poor solvent, and the above object could be achieved. The present invention has been completed based on the knowledge.

The present invention provides:
An organic electroluminescence device which comprises at least one organic thin film layer in a plurality of layers containing at least a light emitting layer and sandwiched between a cathode and an anode those composing the organic electroluminescence device, wherein the organic thin film layer is formed in accordance with a wet process using a mixed solvent comprising a good solvent and a poor solvent;
A process for forming at least one organic thin film layer in a plurality of layers sandwiched between a cathode and an anode those composing an organic electroluminescence device which comprises at least a light emitting layer, wherein the organic thin film layer is formed in accordance with a wet process using a mixed solvent comprising a good solvent and a poor solvent; and
An organic solution for forming at least one organic thin film layer in a plurality of layers sandwiched between a cathode and an anode those composing an organic electroluminescence device which comprises at least a light emitting layer, wherein the solution is obtained by dissolving materials for an organic electroluminescence device forming the organic thin film layer into a mixed solvent comprising a good solvent and a poor solvent.

### EFFECT OF THE INVENTION

In accordance with the present invention, an organic thin film layer comprising a plurality of layers can be formed using any desired materials for an organic EL device in a simple and convenient production step, i.e., in accordance with a wet process, and an organic EL device exhibiting a great efficiency of light emission and having a long lifetime can be obtained. In accordance with the process of the present invention, an organic EL device can be produced at a low cost, and the process is suitable for mass production of the organic EL device.

### THE MOST PREFERRED EMBODIMENT TO CARRY OUT THE INVENTION

The organic EL device of the present invention comprises at least one organic thin film layer in a plurality of layers containing at least a light emitting layer and sandwiched between a cathode and an anode those composing the organic electroluminescence device, wherein the organic thin film layer is formed in accordance with a wet process using a mixed solvent comprising a good solvent and a poor solvent.
The organic EL device of the present invention has a structure in which at least two organic layers are laminated between the electrodes. Examples of the structure include (an anode / a hole injecting·transporting layer / a light emitting layer / an electron injecting·transporting layer / a cathode), (an anode / a hole injecting·transporting layer / a light emitting layer / a cathode) and (an anode / a light emitting layer / an electron injecting transporting layer / a cathode).

In the organic EL device of the present invention, the hole injecting·transporting layer means a hole injecting layer and/or a hole transporting layer. As the hole injecting·transporting material, a compound which has the ability of transporting holes, exhibits the effect of injection of holes from the anode and the excellent effect of injection of holes into the light emitting layer or the light emitting material, prevents transfer of excimers formed in the light emitting layer into the electron injecting layer and has excellent ability of forming a thin film, is preferable. Examples of the hole injecting·transporting material include phthalocyanine derivatives, naphthalocyanine derivatives, porphyrin derivatives, oxazoles, oxadiazoles, triazoles, imidazoles, imidazolones, imidazolethiones, pyrazolines, pyrazolones, tetrahydroimidazoles, hydrazones, acylhydrazones, polyarylalkanes, stilbenes, butadienes, triphenylamines of the benzidine type, triphenylamines of the styrylamine type, triphenylamines of the diamine type, derivatives of these compounds, and polymer materials such as polymers examples of which include polyvinylcarbazoles and polysilanes and electrically conductive polymers typical examples of which include poly(ethylenedioxythiophene)/polystyrenesulfonic acid(PEDOT:PSS) and polyaniline/camphorsulfonic acid (PANI:CSA). However, the hole injecting transporting material is not limited to the compounds described above.
More effective materials among the above hole injecting transporting materials are aromatic tertiary amine derivatives and phthalocyanine derivatives.
Examples of the aromatic tertiary amine derivative include triphenylamine, tritolylamine, tolyldiphenylamine, N,N'-diphenyl-N,N-(3-methylphenyl)-1,1'-biphenyl-4,4'-diamine, N,N,N',N'-(4-methylphenyl)-1,1'-phenyl-4,4'-diamine, N,N,N',N'-(4-methylphenyl)-1,1'-biphenyl-4,4'-diamine, N,N'-diphenyl-N,N'-dinaphthyl-1,1'-biphenyl-4,4'-diamine, N,N'-(methylphenyl)-N,N'-(4-n-butylphenyl)phenanthrene-9,10-diamine, N,N-bis(4-di-4-tolylaminophenyl)-4-phenylcyclohexane, and oligomers and polymers having the skeleton of the above aromatic tertiary amine. However, the aromatic tertiary amine derivative is not limited to the compounds described above.
Examples of the phthalocyanine (Pc) derivative include phthalocyanine derivatives such as H₂Pc, CuPc, CoPc, NiPc, ZnPc, PdPc, FePc, MnPc, ClAlPc, ClGaPc, ClInPc, ClSnPc, Cl₂SiPc, (HO)AlPc, (HO)GaPc, VOPc, TiOPc, MoOPc, GaPc-O-GaPc. However, the phthalocyanine derivative is not limited to the compounds described above.

Examples of the light emitting material used for the above light emitting layer in the organic EL device of the present invention include low molecular weight light emitting materials and polymer light emitting materials. Typical examples of the low molecular weight light emitting material include olefin-based light emitting materials such as 4,4'-(2,2-di-phenylvinyl)biphenyl; anthracene-based light emitting materials such as 9,10-di(2-naphthyl)anthracene, 9,10-bis(3,5-diphenylphenyl)-anthracene, 9,10-bis(9,9-dimethylfluorenyl)anthracene, 9,10-(4-(2,2-diphenylvinyl)phenyl)anthracene, 9,10'-bis(2-biphenylyl)-9,9'-bis-anthracene, 9,10,9',10'-tetraphenyl-2,2'-bianthryl and 1,4-bis(9-phenyl-10-anthracenyl)benzene; spiro-based light emitting materials such as 2,'7,2','7'-tetrakis(2,2-diphenylvinyl)spirobifluorene; carbazole-based light emitting materials such as 4,4'-dicarbazolylbiphenyl and 1,3-dicarbazolyl-benzene; and pyrene-based light emitting materials such as 1,3,5-tripyrenylbenzene. Typical examples of the polymer light emitting material include polyphenylenevinylenes, polyfluorenes and polyvinylcarbazoles. Among these light emitting materials, low molecular weight light emitting materials are preferable, and anthracene-based light emitting material is more preferable as the light emitting material.

The light emitting layer described above may be doped with a fluorescent coloring agent. The concentration of the doping is not particularly limited. It is preferable that the concentration is 0.1 to 20% by weight. Examples of the fluorescent coloring agent include conventional fluorescent coloring agents such as perylene derivatives, pyrene derivatives, chrysene derivatives, phenanthrene derivatives, rubrene derivatives, coumarin derivatives, dicyanomethylenepyrane derivatives, stilbene derivatives, tristyrylarylene derivatives and distyrylarylene derivatives. Among these fluorescent coloring agents, perylene derivatives, pyrene derivatives and distyrylarylene derivatives are preferable, and arylamino-substituted distyrylarylene derivatives and arylamino-substituted pyrene derivatives are more preferable.
The light emitting layer described above may be doped with a phosphorescent coloring agent. The concentration of the doping is not particularly limited. It is preferable that the concentration is 0.1 to 20% by weight. Examples of the phosphorescent coloring agent include platinum complex compounds such as tetraphenylporphyrin platinum complex compound and iridium complex compounds such as tris(2-phenylpyridine)iridium, bis(2-phenylpyridine)(acetylacetonato)-iridium, bis(2,4-difluorophenylpyridine)(picolinato)iridium, bis(2-phenylquinoline)(acetylacetonato)iridium and bis(2-phenylbenzothiazole)-(acetylacetonato)iridium. Among these phosphorescent coloring agents, iridium complex compounds are preferable, and iridium complexes formed into an orthometal are more preferable.

In the organic EL device of the present invention, the electron injecting-transporting layer means an electron injecting layer and/or an electron transporting layer. As the electron injecting-transporting material, a compound which has the ability of transporting electrons, exhibits the effect of injection of electrons from the cathode and the excellent effect of injection of electrons into the light emitting layer or the light emitting material, prevents transfer of excimers formed in the light emitting layer into the hole injecting layer and has excellent ability of forming a thin film, is preferable. Examples of the electron injecting· transporting material include fluorenone, anthraquinodimethane, diphenylquinone, thiopyrane dioxide, oxazole, oxadiazole, triazole, imidazole, perylenetetracarboxylic acid, fluorenylidenemethane, anthrone and derivatives of these compounds. However, the electron injecting-transporting material is not limited to the compounds described above. The property of charge injection can also be improved by adding an electron-accepting substance to the hole injecting material and an electron-donating substance to the electron injecting material.

More effective materials among the above electron injecting· transporting materials are metal complex compounds and five-membered cyclic derivatives having nitrogen atom.
Examples of the metal complex compound include 8-hydroxy-quinolinatolithium, bis(8-hydroxyquinolinato)zinc, bis(8-hydroxy-quinolinato)copper, bis(8-hydroxyquinolinato)manganese, tris(8-hydroxy-quinolinato)aluminum, tris(2-methyl-8-hydroxyquinolinato)aluminum, tris(8-hydroxyquinolinato)gallium, bis(10-hydroxybenzo[h]quinolinato)-beryllium, bis(10-hydroxybenzo[h]quinolinato)zinc, bis(2-methyl-8-quinolinato)chlorogallium, bis(2-methyl-8-quinolinato)(o-cresolato)gallium, bis(2-methyl-8-quinolinato)(1-naphtholato)aluminum and bis(2-methyl-8-quinolinato)(2-naphtholato)gallium. However, the metal complex compound is not limited to the compounds described above.

As the five-membered cyclic derivative having nitrogen atom, derivatives of oxazole, thiazole, oxadiazole, thiadiazole and triazole are preferable. Examples of the five-membered cyclic derivative having nitrogen atom include 2,5-bis(1-phenyl)-1,3,4-oxazole, dimethylPOPOP, 2,5-bis(1-phenyl)-1,3,4-thiazole, 2,5-bis(1-phenyl)-1,3,4-oxadiazole, 2-(4'-tert-butylphenyl)-5-(4"-biphenyl)-1,3,4-oxadiazole, 2,5-bis(1-naphthyl)-1,3,4-oxadiazole, 1,4-bis[2-(5-phenyloxadiazolyl)]benzene, 1,4-bis[2-(5-phenyloxadiazolyl)-4-tert-butylbenzene], 2-(4'-tert-butylphenyl)-5-(4"-biphenyl)-1,3,4-thiadiazole, 2,5-bis(1-naphthyl)-1,3,4-thiadiazole, 1,4-bis-[2-(5-phenylthiadiazolyl)]benzene, 2-(4'-tert-butylphenyl)-5-(4"-biphenyl)-1,3,4-triazole, 2,5-bis(1-naphthyl)-1,3,4-triazole and 1,4-bis[2-(5-phenyltriazolyl)]benzene. However, the five-membered cyclic derivative having nitrogen atom is not limited to the compounds described above.

In the organic EL device of the present invention, leak of the electric current can be effectively prevented and the electron injecting property can be improved when the electron injecting-transporting layer described above is constituted with an insulating material or a semiconductor.
As the insulating material described above, it is preferable that at least one metal compound selected from the group consisting of alkali metal chalcogenide, alkaline earth metal chalcogenide, halides of alkali metals and halides of alkaline earth metals is used. It is preferable that the electron injecting layer is constituted with the above compound such as an alkali metal chalcogenide since the electron injecting property can be further improved.
Examples of the alkali metal chalcogenide include Li₂O, LiO, Na₂S, Na₂Se and NaO. Examples of the alkaline earth metal chalcogenide include CaO, BaO, SrO, BeO, BaS and CaSe. Examples of the halide of an alkali metal include LiF, NaF, KF, LiCl, KCl and NaCl. Examples of the halide of an alkaline earth metal include fluorides such as CaF₂, BaF₂, SrF₂, MgF₂ and BeF₂ and halides other than the fluorides.
Examples of the semiconductor include oxides, nitrides and oxide nitrides having at least one element selected from Ba, Ca, Sr, Yb, Al, Ga, In, Li, Na, Cd, Mg, Si, Ta, Sb and Zn used singly or in combination of two or more.
It is preferable that the inorganic compound as the material for the electron injecting-transporting layer forms a fine crystalline or amorphous insulating thin film. When the electron injecting layer is constituted with the insulating thin film described above, a more uniform thin film can be formed, and defects of pixels such as dark spots can be decreased. Examples of the inorganic compound include alkali metal chalcogenides, alkaline earth metal chalcogenides, halides of alkali metals and halides of alkaline earth metals which are described above.

In the organic EL device of the present invention, the electron injecting transporting layer may comprise a reducing dopant having a work function of 2.9 eV or smaller. The reducing dopant is defined as a substance which can reduce an electron transporting compound. Various compounds can be used as the reducing dopant as long as the compounds have the specific reductive property. For example, at least one substance selected from the group consisting of alkali metals, alkaline earth metals, rare earth metals, oxides of alkali metals, halides of alkali metals, oxides of alkaline earth metals, halides of alkaline earth metals, oxides of rare earth metals, halides of rare earth metals, organic complexes of alkali metals, organic complexes of alkaline earth metals and organic complexes of rare earth metals can be advantageously used.
Preferable examples of the reducing dopant include at least one alkali metal selected from the group consisting of Na (the work function: 2.36 eV), K (the work function: 2.28 eV), Rb (the work function: 2.16 eV) and Cs (the work function: 1.95 eV) and at least one alkaline earth metal selected from the group consisting of Ca (the work function: 2.9 eV), Sr (the work function: 2.0 to 2.5 eV) and Ba (the work function: 2.52 eV). Compounds having a work function of 2.9 eV or smaller are more preferable.
Among the above substances, at least one alkali metal selected from the group consisting of K, Rb and Cs is more preferable, Rb and Cs are still more preferable, and Cs is most preferable as the reducing dopant. These alkali metals have great reducing ability, and the luminance of the emitted light and the life of the organic EL device can be increased by addition of a relatively small amount of the alkali metal into the electron injecting transporting layer.
As the reducing dopant having a work function of 2.9 eV or smaller, combinations of two or more alkali metals are also preferable. Combinations having Cs such as the combinations of Cs and Na, Cs and K, Cs and Rb and Cs, Na and K are more preferable. The reducing ability can be efficiently exhibited by the combination having Cs. The luminance of emitted light and the life of the organic EL device can be increased by adding the combination having Cs into the electron injecting-transporting layer.

In the organic EL device of the present invention, as the electrically conductive material used for the anode, a material having a work function greater than 4 eV is suitable. Carbon, aluminum, vanadium, iron, cobalt, nickel, tungsten, silver, gold, platinum, palladium, alloys of these metals, metal oxides such as tin oxide and indium oxide used for ITO substrates and NESA substrates, and organic electrically conductive resins such as polythiophene and polypyrrol can be used.
In the organic EL device of the present invention, as the electrically conductive material used for the cathode, a material having a work function smaller than 4 eV is suitable. Magnesium, calcium, tin, lead, titanium, yttrium, lithium, ruthenium, manganese, aluminum and alloys of these metals can be used. However, the material for the cathode is not limited to these materials. Typical examples of the alloy include magnesium/silver, magnesium/indium and lithium/aluminum. However, the alloy is not limited to these alloys. The ratio of the amounts of the components in the alloy is controlled by the temperature of the sources of vapor deposition, the atmosphere and the degree of vacuum and adjusted to a suitable value. The anode and the cathode may have a structure having two or more layers, where necessary.

In the organic EL device of the present invention, it is desirable that at least one face of the device is sufficiently transparent in the wavelength range of the light emitted from the device so that the emitted light is efficiently obtained. It is desirable that the substrate is transparent. The transparent electrode is disposed in accordance with a process such as the vapor deposition process or the sputtering process using the above electrically conductive material in a manner such that the prescribed transparency is assured. It is preferable that the electrode on the light emitting face has a transmittance of light of 10% or greater. The substrate is not particularly limited as long as the substrate has sufficient mechanical and thermal strength and transparency. Examples of the substrate include glass substrates and transparent resin films. Examples of the transparent resin films include films of polyethylene, ethylene-vinyl acetate copolymers, ethylene-vinyl alcohol copolymers, polypropylene, polystyrene, polymethyl methacrylate, polyvinyl chloride, polyvinyl alcohol, polyvinyl butyral, nylons, polyether ether ketones, polysulfones, polyether sulfones, tetrafluoroethylene-perfluoroalkyl vinyl ether copolymers, polyvinyl fluoride, tetrafluoroethylene-ethylene copolymers, tetrafluoroethylene-hexafluoropropylene copolymers, polychlorotrifluoroethylene, polyvinylidene fluoride, polyesters, polycarbonates, polyurethanes, polyimides, and polyether imides.

It is possible that a protective layer is formed on the surface or the entire device is protected with a silicone oil or a resin so that stability of the organic EL device obtained in accordance with the present invention to the temperature, the moisture and the atmosphere is improved.
The thickness of each layer in the organic thin film layer in the organic EL device of the present invention is not particularly limited. In general, defects such as pin holes tend to be formed when the thickness is excessively small. A great voltage must be applied when the thickness is excessively great, and the efficiency decreases. In general, the thickness is in the range of several nanometers to 1µm, and a thickness of 10 nanometers to 0.2 µm is preferable.

In the organic EL device of the present invention, it is sufficient that at least one layer in the organic thin film layer is formed in accordance with a wet process, and a process for forming a film other than the wet process (a dry process) such as the vacuum vapor deposition process can be used for other layers.
In the organic EL device of the present invention, the effect of exhibiting the excellent efficiency of light emission and the long lifetime can be obtained even when the organic thin film layer comprising a plurality of layers comprises low molecular weight compounds. In the present invention, the low molecular weight compound means a compound having a molecular weight of 10,000 or smaller.
The organic solution for an organic EL device of the present invention is obtained by dissolving the materials for the organic EL device forming the organic thin film layer into a mixed solvent comprising a good solvent and a poor solvent. In the process for producing an organic EL device of the present invention, the organic thin film layer is formed in accordance with a wet process using the obtained organic solution.
In the present invention, the good solvent means a solvent which dissolves 1% by weight or more of a material for an organic EL device as the solute (a solubility of 1% by weight or greater), and the poor solvent means a solvent which dissolves less than 1% by weight of a material for an organic EL device as the solute (a solubility smaller than 1% by weight). It is preferable the solubility in the good solvent is 1.5% by weight or greater, and the solubility in the poor solvent is 0.1% by weight or smaller.

The type of the solvent in the present invention is not particularly limited as long as the above solubility is satisfied, and a conventional solvent can be used. Examples of the solvent include halogen-based hydrocarbon-based solvents such as dichloromethane, dichloroethane, chloroform, carbon tetrachloride, tetrachloroethane, trichloroethane, chlorobenzene, dichlorobenzene and chlorotoluene; ether-based solvents such as dibutyl ether, tetrahydrofuran, dioxane and anisole; alcohol-based solvents such as methanol, ethanol, propanol, butanol, pentanol, hexanol, cyclohexanol, 2-methoxyethanol, 2-ethoxyethanol, ethylene glycol and glycerol; aromatic solvents such as benzene, toluene, xylene and ethylbenzene; paraffin-based solvents such as hexane, octane, decane and tetraline; ester-based solvents such as ethyl acetate, butyl acetate and amyl acetate; amide-based solvents such as N,N-dimethylformamide, N,N-dimethylacetamide and N-methylpyrrolidone; ketone-based solvents such as acetone, methyl ethyl ketone, cyclohexanone and isophorone; amine-based solvents such as pyridine, quinoline and aniline; nitrile-based solvents such as acetonitrile and valeronitrile; and sulfur-based solvents such as thiophene and carbon disulfide. However, solvents which can be used are not limited to the solvents described above. By selecting a good solvent and a poor solvent from the above solvents and using the selected solvents as a mixture of two or more, it is made possible that the solubility of the material for an organic EL device is controlled easily.
As for the preferable examples among the above solvents, examples of the good solvent include aromatic solvents, halogen-based solvents and ether-based solvents. Aromatic solvents and ether-based solvents are more preferable. Examples of the poor solvent include alcohol-based solvents, ketone-based solvents and paraffin-based solvents. Alcohol-based solvents and paraffin-based solvents are more preferable, and alcohol-based solvents are most preferable.

The concentration of the material for an organic EL device which is dissolved into the mixed solvent comprising the good solvent and the poor solvent is not particularly limited as long as the concentration is suitable for forming a film having the desired thickness. The concentration is preferably 0.01 to 95% by weight and more preferably 0.1 to 80% by weight.
The ratio of the amounts of the good solvent to the poor solvent is not particularly limited as long as the material for an organic EL device is dissolved in the concentration described above and the film of the lower layer is not dissolved. The amount of the poor solvent is preferably 50% by volume or more and more preferably 80% by volume or more. When the amount of the poor solvent is 50% by volume or more, the film having a multilayer structure can be formed without dissolution of the film of the lower layer since the solubility of the material for an organic EL device is not much different depending on the type of the compound, and an organic EL device achieving a great performance can be obtained.

For forming each layer in the organic EL device of the present invention, a dry process such as the vacuum vapor deposition process, the sputtering process, the plasma process and the ion plating process or a wet process such as the spin coating process, the dipping process, the casting process, the roll coating process, the flow coating process and the ink jet process can be used. At least one layer among the layers of the organic thin film layer is formed in accordance with the wet process.
In each layer forming the organic thin film layer, suitable resins and additives may be used for improving the property for film formation and preventing formation of pin holes. Examples of the resin include insulating resins such as polystyrene, polycarbonates, polyarylates, polyesters, polyamides, polyurethanes, polysulfones, polymethyl methacrylate, polymethyl acrylate and cellulose; copolymers of the insulating resins; photoconductive resins such as poly-N-vinylcarbazole and polysilanes; and electrically conductive resins such as polythiophene and polypyrrol. Examples of the additive include antioxidants, ultraviolet light absorbents and plasticizers.

### EXAMPLES

The present invention will be described more specifically with reference to examples in the following. However, the present invention is not limited to the examples.

### Example 1

A glass substrate (manufactured by GEOMATEC Company) of 25 mm × 75 mm × 1.1 mm thickness having an ITO transparent electrode was cleaned by application of ultrasonic wave in isopropyl alcohol for 5 minutes and then by exposure to ozone generated by ultraviolet light for 30 minutes. The cleaned glass substrate having the transparent electrode was attached to a substrate holder of a vacuum vapor deposition apparatus. On the surface of the cleaned substrate at the side having the transparent electrode, a film of N,N'-bis(4-diphenylaminophenyl)-N,N'-diphenyl-4,4'-diaminobiphenyl (a TPD232 film) having a thickness of 40 nm was formed in accordance with the vacuum vapor deposition process in a manner such that the formed film covered the transparent electrode. The formed TPD232 film worked as the hole injecting layer. On the formed TPD232 film, a film of N,N,N',N'-tetrakis(4-biphenyl)-4,4'-benzidine (a BPTPD film) having a thickness of 40 nm was formed in accordance with the vacuum vapor deposition process. The formed BPTPD film worked as the hole transporting layer. Then, as the materials for forming the light emitting layer, 9,10-bis(3-(1-naphthyl)-phenyl)-2-(2-biphenylyl)anthracene (the molecular weight: 734) and 1,6-bis(diphenylamino)pyrene (the molecular weight: 536) in relative amounts by weight of were dissolved into a mixed solvent containing dioxane and isopropyl alcohol (relative amounts by volume: 1:8), and a coating solution containing 3% by weight of the materials for forming the light emitting layer was prepared. Dioxane was used as the good solvent and had a solubility of the materials for forming the light emitting layer of 10% by weight or greater. Isopropyl alcohol was used as the poor solvent and had a solubility of the materials for forming the light emitting layer of 0.1% by weight or smaller. Using the prepared coating solution, a light emitting layer having a thickness of 40 nm was formed on the BPTPD film formed above in accordance with the spin coating process. Then, the obtained coated substrate was attached to the substrate holder in the vacuum vapor deposition apparatus, and a film of tris(8-hydroxyquinoline)aluminum (Alq) having a thickness of 30 nm was formed in accordance with the vacuum vapor deposition process. The formed Alq film worked as the electron transporting layer. A film of lithium fluoride having a thickness of 1 nm was formed in accordance with the vacuum vapor deposition process to form an electron injecting layer. As the last step, an aluminum film of the cathode was formed in accordance with the vacuum vapor deposition process, and an organic EL device was fabricated.
When a voltage of 5.0 V was applied to the obtained device, an electric current of 2.5 mA/cm² was obtained, and blue light having a chromaticity coordinates of (0.15, 0.26) was obtained at a luminance of emitted light of 92 cd/m². The current efficiency of light emission was 3.7 cd/A and 2.3 lumen/W. Further, as a result of subjecting the device to a continuous test at a room temperature by feeding a constant electric current starting at an initial luminance of 100 cd/m², it was confirmed that the half lifetime thereof was 2,600 hours.

### Example 2

An organic EL device was fabricated in accordance with the same procedures as those conducted in Example 1 except that the relative amounts by volume of dioxane and isopropyl alcohol in the mixed solvent for dissolving the materials for forming the light emitting layer were changed to 1:6.
When a voltage of 5.5 V was applied to the obtained device, an electric current of 4.5 mA/cm² was obtained, and blue light having a chromaticity coordinates of (0.15, 0.26) was obtained at a luminance of emitted light of 219 cd/m². The current efficiency of light emission was 4.6 cd/A and 2.7 lumen/W. Further, as a result of subjecting the device to a continuous test at a room temperature by feeding a constant electric current starting at an initial luminance of 100 cd/m², it was confirmed that the half lifetime thereof was 4,000 hours.

### Example 3

An organic EL device was fabricated in accordance with the same procedures as those conducted in Example 1 except that the types and the relative amounts of component solvents in the mixed solvent for dissolving the materials for forming the light emitting layer were changed, and toluene and n-butanol were used in relative amounts by volume of 1:6. Toluene was used as the good solvent and had a solubility of the materials for forming the light emitting layer of 10% by weight or greater. n-Butanol was used as the poor solvent and had a solubility of the materials for forming the light emitting layer of 0.1% by weight or smaller.
When a voltage of 6.0 V was applied to the obtained device, an electric current of 4.2 mA/cm² was obtained, and blue light having a chromaticity coordinates of (0.15, 0.26) was obtained at a luminance of emitted light of 200 cd/m². The current efficiency of light emission was 4.8 cd/A and 2.5 lumen/W. Further, as a result of subjecting the device to a continuous test at a room temperature by feeding a constant electric current starting at an initial luminance of 100 cd/m², it was confirmed that the half lifetime thereof was 1,800 hours.

### Example 4

A glass substrate (manufactured by GEOMATEC Company) of 25 mm × 75 mm × 1.1 mm thickness having an ITO transparent electrode was cleaned by application of ultrasonic wave in isopropyl alcohol for 5 minutes and then by exposure to ozone generated by ultraviolet light for 30 minutes. On the cleaned substrate, a film of the hole injecting layer having a thickness of 10 nm was formed using a 1% by weight aqueous solution of polyethylenedioxythiophene / polystyrenesulfonic acid (PEDOT:PSS) in accordance with the spin coating process. On the formed film, a film of the hole transporting layer having a thickness of 50 nm was formed using a 1% by weight toluene solution of N,N-bis(4-diphenylaminobiphenylyl-4')aniline in accordance with the spin coating process. Then, as the materials for forming the light emitting layer, 9,10-bis(3-(2-naphthyl)phenyl)-2-(4'-t-butyl-2-biphenylyl)anthracene (the molecular weight: 790) and 1,6-bis(diphenylamino)pyrene (the molecular weight: 536) in relative amounts by weight of 20:2 were dissolved into a mixed solvent containing dioxane and isopropyl alcohol (relative amounts by volume: 1:8), and a coating solution containing 1% by weight of the materials for forming the light emitting layer was prepared. Dioxane was used as the good solvent and had a solubility of the materials for forming the light emitting layer of 10% by weight or greater. Isopropyl alcohol was used as the poor solvent and had a solubility of the materials for forming the light emitting layer of 0.1% by weight or smaller. Using the prepared coating solution, a light emitting layer having a thickness of 30 nm was formed on the film of the hole transporting layer formed above in accordance with the spin coating process. Then, the obtained coated substrate was attached to the substrate holder in the vacuum vapor deposition apparatus, and a film of Alq having a thickness of 30 nm was formed in accordance with the vacuum vapor deposition process. The formed Alq film worked as the electron transporting layer. A film of lithium fluoride having a thickness of 1 nm was formed in accordance with the vacuum vapor deposition process to form an electron injecting layer. As the last step, an aluminum film of the cathode was formed in accordance with the vacuum vapor deposition process, and an organic EL device was fabricated.
When a voltage of 5.5 V was applied to the obtained device, an electric current of 3.5 mA/cm² was obtained, and blue light having a chromaticity coordinates of (0.15, 0.26) was obtained at a luminance of emitted light of 102 cd/m². The current efficiency of light emission was 2.9 cd/A and 1.7 lumen/W. Further, as a result of subjecting the device to a continuous test at a room temperature by feeding a constant electric current starting at an initial luminance of 100 cd/m², it was confirmed that the half lifetime thereof was 400 hours.

### Comparative Example 1

An organic EL device was fabricated in accordance with the same procedures as those conducted in Example 1 except that dioxane was used singly as the solvent for dissolving the materials for forming the light emitting layer.
When a voltage of 6 V was applied to the obtained device, an electric current of 9.9 mA/cm² was obtained, and blue light having a chromaticity coordinates of (0.15, 0.30) was obtained at a luminance of emitted light of 77 cd/m². The current efficiency of light emission was as small as 0.8 cd/A and 0.4 lumen/W. Further, as a result of subjecting the device to a continuous test at a room temperature by feeding a constant electric current starting at an initial luminance of 100 cd/m², it was found that the half lifetime thereof was as short as 62 hours.

### Comparative Example 2

An organic EL device was fabricated in accordance with the same procedures as those conducted in Example 3 except that toluene was used singly as the solvent for dissolving the materials for forming the light emitting layer.
When a voltage of 6.0 V was applied to the obtained device, an electric current of 15 mA/cm² was obtained, and blue light having a chromaticity coordinates of (0.15, 0.33) was obtained at a luminance of emitted light of 92 cd/m². The current efficiency of light emission was as small as 0.6 cd/A and 0.3 lumen/W. Further, as a result of subjecting the device to a continuous test at a room temperature by feeding a constant electric current starting at an initial luminance of 100 cd/m², it was found that the half lifetime thereof was as short as 33 hours.

### Comparative Example 3

An organic EL device was fabricated in accordance with the same procedures as those conducted in Example 4 except that dioxane was used singly as the solvent for dissolving the materials for forming the light emitting layer.
When a voltage of 6.5 V was applied to the obtained device, an electric current of 43 mA/cm² was obtained, and blue light having a chromaticity coordinates of (0.15, 0.34) was obtained at a luminance of emitted light of 130 cd/m². The current efficiency of light emission was as small as 0.3 cd/A and 0.5 lumen/W. Further, as a result of subjecting the device to a continuous test at a room temperature by feeding a constant electric current starting at an initial luminance of 100 cd/m², it was found that the half lifetime thereof was as short as 16 hours.

### INDUSTRIAL APPLICABILITY

As described specifically in the above, in accordance with the present invention, the organic thin film layer having a plurality of layers can be formed in a simple and convenient production step, i.e., in accordance with a wet process, using any desired materials for an organic EL device, and the organic EL device exhibiting an excellent efficiency of light emission and having a long lifetime can be obtained. Therefore, the organic EL device can be produced at a low cost in accordance with the process of the present invention, and the process is suitable for the mass production of the organic EL device.
The organic EL device of the present invention has practically valuable properties and is very useful as the planar light emitting member such as flat panel displays, the backlight for copiers, printers and liquid crystal displays, the light source for instruments, signboards and beacon lights.

## Claims

1. An organic electroluminescence device which comprises at least one organic thin film layer in a plurality of layers containing at least a light emitting layer and sandwiched between a cathode and an anode those composing the organic electroluminescence device, wherein the organic thin film layer is formed in accordance with a wet process using a mixed solvent comprising a good solvent and a poor solvent.

2. An organic electroluminescence device according to Claim 1, wherein an amount of the poor solvent in the mixed solvent is 50% by volume or more.

3. An organic electroluminescence device according to Claim 1, wherein an amount of the poor solvent in the mixed solvent is 80% by volume or more.

4. An organic electroluminescence device according to any one of Claims 1 to 3, wherein the poor solvent is an alcohol-based solvent.

5. An organic electroluminescence device according to any one of Claims 1 to 3, wherein the organic thin film layer comprises low molecular weight compounds.

6. A process for forming at least one organic thin film layer in a plurality of layers sandwiched between a cathode and an anode those composing an organic electroluminescence device which comprises at least a light emitting layer, wherein the organic thin film layer is formed in accordance with a wet process using a mixed solvent comprising a good solvent and a poor solvent.

7. An organic solution for forming at least one organic thin film layer in a plurality of layers sandwiched between a cathode and an anode those composing an organic electroluminescence device which comprises at least a light emitting layer, wherein the solution is obtained by dissolving materials for an organic electroluminescence device forming the organic thin film layer into a mixed solvent comprising a good solvent and a poor solvent.

8. An organic solution according to Claim 7, wherein the good solvent is a solvent dissolving 1% by weight or more of materials for an organic electroluminescence device, and the poor solvent is a solvent dissolving less than 1% by weight of materials for an organic electroluminescence device.
